# EUROPEAN PATENT APPLICATION

(11) **EP 4 250 363 A1**
(43) Date of publication of application: **27.09.2023**
(21) Application number: 22195777.2
(22) Date of filing: 15.09.2022
(51) Int. Cl.: H01L 27/15, H01L 33/00, H01L 33/14, H01L 33/20

(54) **METHOD FOR MAKING MESA STRUCTURES AND OPTICAL DEVICE USING THE SAME**

(30) Priority: 24.03.2022 EP 22164107
(71) Applicant: Micledi Microdisplays BV, 3000 Leuven (BE)
(72) Inventor: Johan, Vertommen, 3220 Holsbeek (BE); Soeren, Steudel, 3020 Herent (BE); Emmanuel le Boulbar, 1970 Wezembeek-Oppem (BE)
(74) Representative: Körfer, Thomas

(57) **Abstract**

A method (100) is provided for making light emitting mesa structures on a semiconductor wafer, each mesa structure comprising a first doped layer, a second doped layer, and an emission layer in-between. The method comprises the steps of providing (101) a first mask for assigning a shape of a sidewall of the mesa structures, etching (102) from the first doped layer according to the first mask up to the emission layer, providing (103) a second mask for assigning a shape of a trench between two adjacent mesa structures, and etching (104) the trench through the emission layer according to the second mask. In this regard, the trench is nonadjacent to the sidewall of the mesa structures.

## Description

The invention relates to applications that require devices made in a compound semiconductor, especially are tightly co-integrated with CMOS logic, whereby the wafer with the compound semiconductor is bonded wafer-to-wafer with a Si-CMOS wafer.

Generally, the micro-LED is standardly a direct bandgap compound semiconductor material and the pixel engine is standardly done in Si-CMOS. This combination requires an assembly technology to realize a display, e.g. for augmented reality applications. During the manufacturing process of the micro-LED displays, the individual pixels are defined by etching arrays of mesa shaped structures in the epitaxial wafer. For example, the document EP 3 667 745 A1 presents a method for obtaining micro-LEDs reconstructed over a carrier substrate.

However, the resulting mesa etched structures need to be electrically isolated from each other. To obtain electrical isolation, in most cases, it cannot be avoided that the etch goes through the multi-quantum wells (MQW). A known side effect of etching the MQW's is the sidewalls of the QW's in the mesa's are damaged resulting in non-radiative recombination of electron hole pairs with a loss of optical efficiency (output) as a result.

Accordingly, an object of the invention is to provide a method for making mesa structures and an optical device that can address the aforementioned limitations and to increase the efficiency of the micro-LEDS.

The object is solved by the features of the first independent claim for the method, and by the features of the second independent claim for the optical device. The dependent claims contain further developments.

According to a first aspect of the invention, a method is provided for making light emitting mesa structures on a semiconductor wafer, each mesa structure comprising a first doped layer or a first highly-doped contact layer, a second doped layer or a second highly-doped contact layer, and an emission layer or an active layer in-between. The method comprises the steps of providing a first mask for assigning a shape of a sidewall or sidewalls of the mesa structures, etching from the first doped layer, especially to form the sidewalls of the mesa structures, according to the first mask up to the emission layer, providing a second mask for assigning a shape of a trench or cut between two adjacent mesa structures, and etching the trench through the emission layer according to the second mask.

In this regard, the trench is nonadjacent to the sidewall or the sidewalls of the mesa structures. Additionally, the method may comprise the step of etching the trench from the first doped layer through the emission layer according to the second mask, preferably up to a portion of the second doped layer.

Therefore, the proposed solution reduces the effect of the non-radiative electron/hole-recombination on the radiation output of the pixel by moving the damaged side walls of the MQW's away from the area of MQW's from which useful light is extracted. The proposed scheme particularly changes the shape of the mesa in a way to form a partial mesa structure, so that the damaged area is moved away from the emitting area of the MQW's, especially by means of a very narrow trench in between the mesa's, whereby achieving electrical isolation for the light emitting mesa structures.

Preferably, the method comprises the steps of providing a stop layer or etch stop layer between the first doped layer and the emission layer, etching from the first doped layer according to the first mask up to the stop layer above the emission layer, and etching the trench from the stop layer through the emission layer according to the second mask. This advantageously facilitates an effective etching for the mesa sidewalls, especially from the first doped layer, and further to stop the etching process close to but before reaching the emission layer.

Preferably, the etching from the first doped layer according to the first mask is performed in a first etch step and the etching of the trench through the emission layer according to the second mask is performed in a second etch step. In this regard, the first etch step and the second etch step are performed sequentially. For instance, a litho-etch-litho-etch (LELE) process can be implemented in order to first print and etch the mesa structure, especially the partial mesa structure, and subsequently print and etch the trench or cut.

Alternatively, the etching from the first doped layer according to the first mask and the etching of the trench through the emission layer according to the second mask are performed simultaneously. In other words, the first etch step and the second etch step may be performed simultaneously.

Preferably, the method comprises the steps of providing the first mask for assigning the shape of the sidewall of the mesa structures, etching from the first doped layer according to the first mask up to the emission layer, providing a silicon based carrier substrate and hybrid bonding the semiconductor wafer to the silicon based carrier substrate on the first doped layer side, providing the second mask for assigning the shape of the trench between two adjacent mesa structures, etching the trench from the second doped layer through the emission layer according to the second mask.

In this regard, the trench is nonadjacent to the sidewall of the mesa structures. In addition, the method may further comprise the step of restoring and/or implementing a common contact layer on the second doped layer.

Therefore, an alternative fabrication process is incorporated where the partial mesa structures are fabricated from the first doped layer, especially during the processing of the first doped layer, such as contacts, application of bonding material, and so on. However, the trench or cut is implemented from the second doped layer, especially during the processing of the second doped layer, after the semiconductor wafer with the partial mesa structures is flipped and is bonded, particularly a hybrid bonding, to a CMOS IC.

Preferably, the method comprises the steps of providing a stop layer between the first doped layer and the emission layer, etching from the first doped layer according to the first mask up to the stop layer above the emission layer, and etching the trench from the second doped layer up to the stop layer through the emission layer according to the second mask. This advantageously facilitates an effective etching for the mesa sidewalls, especially from the first doped layer, and further to stop the etching process close to but before reaching the emission layer. This may further assist the etching of the trench from the second doped layer and further to stop the etching process.

Preferably, the method further comprises the step of passivating exposed areas or trench sidewalls along the trench. In this regard, the passivating step comprises performing atomic layer deposition and/or ion implantation and/or bombarding with plasma. The application of a passivation layer advantageously protects the trench sidewalls during subsequent processing steps and further prevents current leakage around the emission layer.

Preferably, the method further comprises the step of filling the trench with a filling material. In this regard, the filling material is a reflective material or a dielectric material or a metal. Advantageously, a high degree of optical isolation between the mesa structures can be achieved, especially by filling the trench with a reflecting or reflective material.

According to a second aspect of the invention, an optical device is provided. The optical device comprises a plurality of light emitting mesa structures on a semiconductor wafer, each mesa structure comprising a first doped layer, a second doped layer, and an emission layer in-between. In this regard, a sidewall of the mesa structures is configured to be etched from the first doped layer up to the emission layer according to a first mask. Furthermore, a trench is configured to be etched through the emission layer between two adjacent mesa structures according to a second mask. Moreover, the trench is nonadjacent to the sidewall of the mesa structures.

Preferably, the plurality of light emitting mesa structures each have a partial mesa shape comprising a mesa part defined by the sidewall followed by an offset part defined by the trench. The offset part is configured to be formed as an elongated part of the partial mesa shape in a direction normal or orthogonal to the mesa part.

In this regard, the mesa part comprises the first doped layer and the offset part comprises at least the emission layer and the second doped layer. Advantageously, the top part of the mesa structure is formed as a traditional mesa shape in order to control the light emitting zone and the bottom part of the mesa structure is offsetted in order to achieve a high electrical isolation.

Preferably, the optical device further comprises a silicon based carrier substrate, wherein the semiconductor wafer is hybrid bonded to the silicon based carrier substrate on the first doped layer side. In this regard, the semiconductor wafer, especially after forming the plurality of light emitting mesa structures, is flipped and is hybrid bonded to the silicon based carrier substrate on the first doped layer side of the semiconductor wafer.

Preferably, the optical device further comprises a common contact layer on the second doped layer along the plurality of light emitting mesa structures. More preferably, the common contact layer comprises or is a transparent conducting oxide layer or coating.

Preferably, the first doped layer is an n-doped layer, especially an n-type Gallium Nitride (nGaN) layer, and/or the second doped layer is a p-doped layer, especially a p-type Gallium Nitride (pGaN) layer, and/or the emission layer is a quantum well layer, especially an Indium Gallium Nitride (InGaN) and/or a Gallium Nitride (GaN) based multiple quantum well (MQW) multi-layer.

Preferably, the shape of the sidewall of the mesa cross-section structures or a cross-section of the mesa structure is a slope shape. Furthermore, the shape of the trench cross-section or a cross-section of the trench is a square shape or a slope shape or a V-shape. In this regard, the trench has a dimension at least of one-tenth of a dimension of the mesa structures. The shapes and the dimensions advantageously allow for a narrow trench or cut that can be applied as far away as possible from the center of the mesa structure in order to pull the damaged zone as far as possible away from the emission zone.

It is to be noted that the optical device according to the second aspect corresponds to the method according to the first aspect and its implementation forms. Accordingly, the optical device of the second aspect achieves the same advantages and effects as the method of the first aspect and its respective implementation forms.

Exemplary embodiments of the invention are now further explained with respect to the drawings by way of example only, and not for limitation. In the drawings:
- Fig. 1: shows an exemplary embodiment of the method according to the first aspect of the invention;
- Fig. 2A: shows conventional mesa structures on an epitaxial wafer;
- Fig. 2B: shows the sidewall effects of conventional mesa structures;
- Fig. 2C: shows a microscope image of conventional mesa structures;
- Fig. 3A: shows a first process step of a first exemplary embodiment of the fabrication process;
- Fig. 3B: shows a second process step of the first exemplary embodiment of the fabrication process;
- Fig. 4A: shows an exemplary process time-lapse for the first exemplary embodiment of the fabrication process;
- Fig. 4B: shows the sidewall effects of the mesa structures of Figs. 3A-3B;
- Fig. 5A: shows a first process step of a second exemplary embodiment of the fabrication process;
- Fig. 5B: shows a second process step of the second exemplary embodiment of the fabrication process;
- Fig. 5C: shows a third process step of the second exemplary embodiment of the fabrication process;
- Fig. 5D: shows a fourth process step of the second exemplary embodiment of the fabrication process;
- Fig. 5E: shows a fifth process step of the second exemplary embodiment of the fabrication process;
- Fig. 6A: shows a first process step of a third exemplary embodiment of the fabrication process;
- Fig. 6B: shows a second process step of the third exemplary embodiment of the fabrication process;
- Fig. 6C: shows a third process step of the third exemplary embodiment of the fabrication process;
- Fig. 6D: shows a fourth process step of the third exemplary embodiment of the fabrication process; and
- Fig. 6E: shows a fifth process step of the third exemplary embodiment of the fabrication process.

Reference will now be made in detail to the embodiments of the present invention, examples of which are illustrated in the accompanying drawings. However, the following embodiments of the present invention may be variously modified and the range of the present invention is not limited by the following embodiments. Reference signs for similar entities in different embodiments are partially omitted.

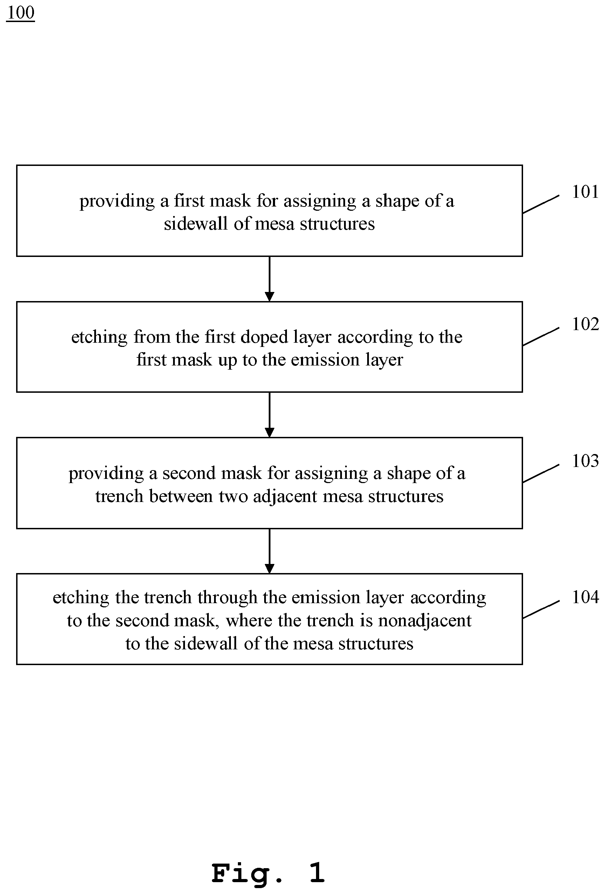

In Fig. 1, an exemplary embodiment of the method 100 according to the first aspect of the invention is illustrated. In a first step 101, a first mask is provided for assigning a shape of a sidewall of mesa structures or a shape of partial mesa structures. In a second step 102, etching is performed up to the emission layer from the first doped layer, especially to form the sidewalls of the mesa structures or to form the partial mesa structures e.g. with the defined sidewall shape, according to the first mask. In a third step 103, a second mask is provided for assigning a shape of a trench between two adjacent mesa structures or partial mesa structures.

Finally, in a fourth step 104, the trench is etched through the emission layer, preferably up to a portion of the second doped layer, according to the second mask, thereby forming the light emitting mesa structures, where the trench is etched nonadjacent to the sidewalls of the mesa structures. In other words, the trench in-between two neighboring partial mesa structures is nonadjacent to said partial mesa structures.

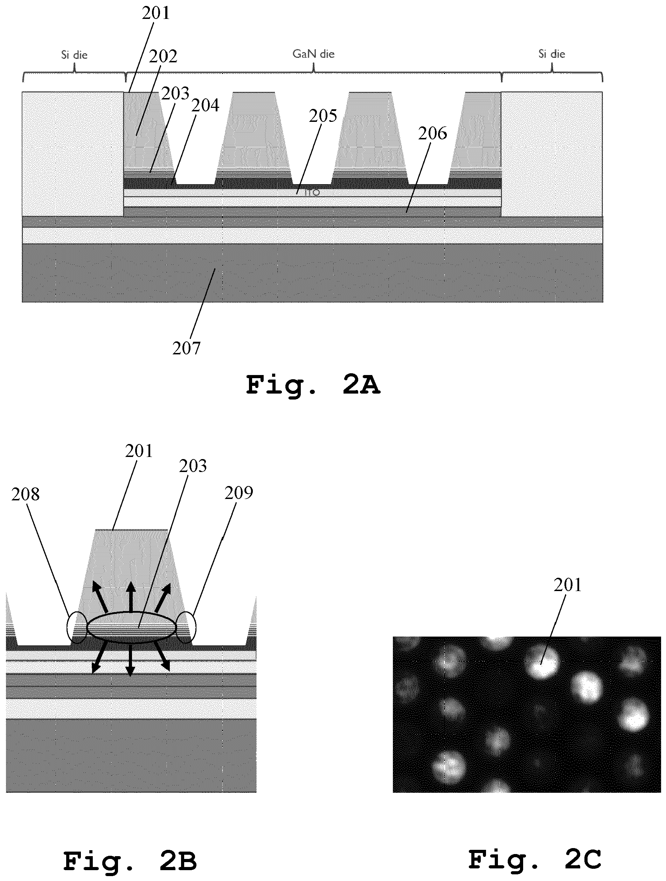

In Figs. 2A-2C, conventional mesa structures 201 are illustrated that are fabricated on an epitaxial wafer or epitaxial light emitting diode (LED) material die. Particularly, Fig. 2A shows an epitaxial LED stack consist of an n-region 202, a p-region 204, separated with the MQW's 203 in-between. Fig. 2A further shows an ITO layer 205 below the p-region 204, a number of dielectric films 206 below the ITO layer 205, and the silicon waver 207. After the etch process, mesa structures 201, e.g. circular mesa shaped structures, are pattered into the epitaxial material to create the individual LED pixel.

In order to make sure that neighboring pixels are electrically isolated, the n-region 202 is completely removed or etched, also the QW's 203 and partially the p-region 204. This is due to the difficulty of defining the etch endpoint since only a small difference in chemical composition can be detected and the exposed etch area being very small. Furthermore, the non-uniform thickness of the epitaxial wafer makes it very difficult to uniformly stop above the QW's 203.

Fig. 2B shows a single mesa structure 201 that includes the n-region 202, p-region 204, and the MQW's 203. It is shown that the mesa is etched by completely removing the n-region 202, MQW's 203, and is stopped at about the middle of the p-region 204. This results in the exposed sidewalls 208, 209 that are damaged, resulting in non-radiative recombination of electron-hole pairs with a loss of output.

The effect of side wall damage can also be seen in Fig. 2B and Fig. 2C. Fig. 2B illustrates that no light is generated in the areas within the black circle at the respective sidewalls 208, 209, effectively reducing the surface of the QW's 203 that are radiating light. The degree to which the sidewall damages reduces the emission of light (i.e. how far it extends away from the sidewalls) is largely dependent on the material properties of the QW's 203 and the degree to which the sidewalls are damaged.

However, it can extend 100's of nanometers away from the sidewall. At large mesa size, the effect of the radiation losses near the edge of the pixels is negligible, but for smaller mesa size, the effect becomes relatively more important. Fig. 2C shows a microscope image of the etched mesas 201, especially corresponds to 2 micrometers blue mesas. It can be seen that less light is emitted from the edge of the pixels.

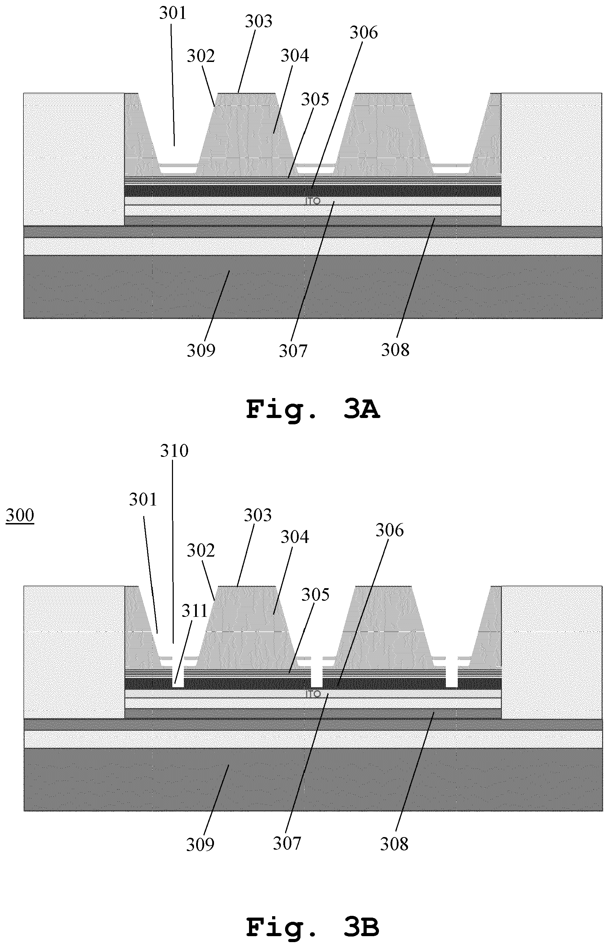

In Figs. 3A-3B, a first exemplary embodiment of the fabrication process according to the invention is illustrated. Particularly, Fig. 3A shows a first etch step to etch partial mesa structures 303 on an incoming epitaxial LED material die.

The epitaxial LED material die includes a first doped layer 304, here illustrated as an n-doped layer (e.g. silicon doped n-type gallium nitride, nGaN), a second doped layer 306, here illustrated as a p-doped layer (e.g. magnesium doped p-tape gallium nitride, pGaN), an active or emission layer 305 in-between the nGaN and the pGan layers, here illustrated as MQW's (e.g. indium gallium nitride, InGaN, or gallium nitride, GaN), an ITO layer 307 underneath the pGaN layer 306, a number of dielectric films 308 underneath the ITO layer 307, and the silicon wafer 309 (e.g. a 775um silicon wafer).

Fig. 3A further shows the application of a first mask 301 that assigns the shape of sidewalls 302 of the mesa structures 303. Accordingly, the mesa's 303 are etched from the nGaN layer 304 up to the MQW's 305, resulting in partial mesa structures. In other words, the partial mesa structures 303 may not be electrically isolated depending on how much the nGaN material is left above the MQW's 305. It is to be noted that the partial mesa structures 303 are etched to approach the MQW's 305 as closely as possible without etching the MQW layer in order to define the emission zone of the MQW's 305.

For instance, in order to achieve high reliability in the etching process, the epitaxial LED material die may be pre-formulated to have an additional layer (not shown) in the nGaN layer 304, or between the nGaN layer 304 and the emission layer 305, which can be utilized as an etch stop layer during the partial mesa formation.

Preferably, the cross-section of the mesa structure 303 has a shape of a slope and the mesa structures 303 are circular mesa structures. However, any shapes suitable for the above-mentioned fabrication scheme are also incorporated.

Fig. 3B shows a second etch step to be performed on the partial mesa structures 303, especially to form the optical device 300 comprising the LED pixels or mesa structures 303. Particularly, Fig. 3B shows the application of a second mask 310 that assigns the shape of a trench or cut 311, especially to be etched between two adjacent partial mesa structures 303. For instance, the trench 311 is etched from the residual nGaN layer 304 above the MQW's 305, or from the etch stop layer if implemented, and is etched through the MQW's 305 and a portion (e.g. one half) of the pGaN layer 306.

Preferably, in a first etch step, the mesa 303 is printed and is etched. In a second etch step, the trench or cut 311 is subsequently printed and is etched. As such, a Litho-Etch-Litho-Etch technique can be used to achieve the above-mentioned sequential etching.

Alternatively, it is possible to perform a partial trench etch followed by mesa etch. As such, during the mesa etch, both the etch front of the trench and the mesa progress together. In this regard, the etch process is optimized such that the MQW's are cut everywhere on the wafer at the point when the mesa etch front is pre-endpointed before it reaches the MQW's.

The trench 311 is preferably a deep cut that is applied through all the conductive layers in order to provide effective electrical isolation. Furthermore, the trench 311 is etched as far away as possible from the center of the mesa structures or partial mesa structures 303, especially to pull the damaged zone as far away as possible from the emission zone.

For instance, the trench or cut dimensions are selected to be less than one-tenth of the mesa dimensions to achieve a deep but narrow trench 311 in-between the neighboring mesa structures 303. Preferably, the cross-section of the trench 311 has a shape of a square or a slope or a V-shape. However, any shapes suitable for the above-mentioned fabrication scheme are also incorporated.

Although not shown, the sidewalls of the mesa structures may be passivated or repaired to improve the performance further. For instance, the passivation may include atomic layer deposition, ion implantation, bombarding with plasma, or any combination thereof. The ion implantation may be performed using nitrogen, argon, krypton, oxygen, silicon, selenium, beryllium, chlorine, boron, fluorine, or boron fluoride. The bombarding with plasma may be performed by bombarding the exposed edges of the light emitting mesa structures with plasma comprising nitrogen, argon, krypton, or oxygen.

Although not shown, the trench 311 may be filled with a filling material. The filling material can be a dielectric material (e.g. SiN materials), a reflective material, or a metal. Particularly by filling the trench 311 with a reflective material, the neighboring pixels can be optically isolated, resulting in the blocking of cross-talk.

As such, the optical device 300 comprises a plurality of light emitting mesa structures that includes the partial mesa structures 303 that are etched in the nGaN layer 304 and are etched up to the MQW's 305, and further includes the trenches 311 in-between two neighboring partial mesa structures 303 that are etched from the nGaN layer 304 through the MQW's 305 and up to a portion (e.g. one half) of the pGaN layer 306, and may optionally include the filling material within the trenches 311.

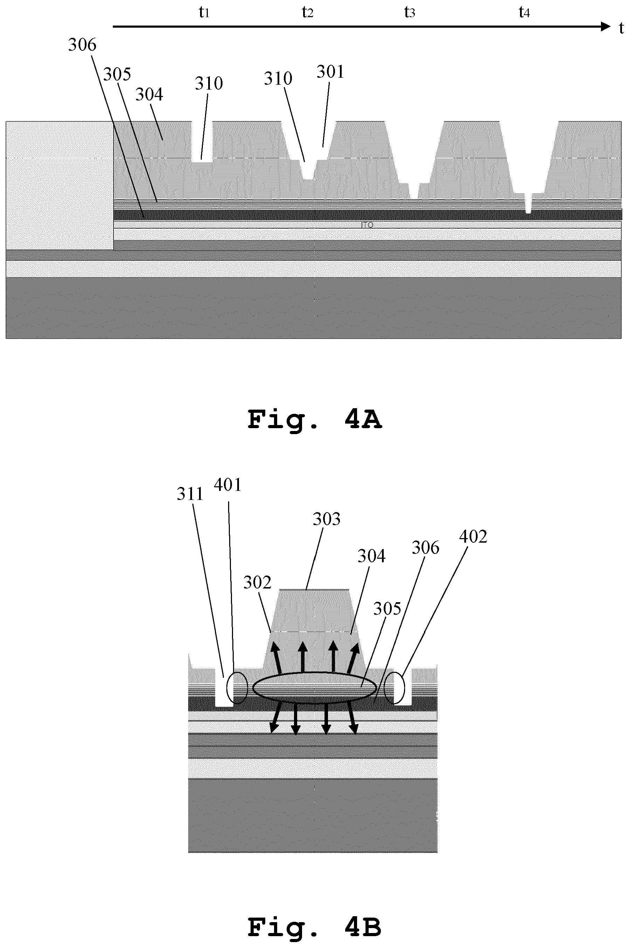

In Fig. 4A, shows an exemplary process time-lapse for the first exemplary embodiment of the fabrication process. Herein, the incoming epitaxial LED material die is illustrated with the nGaN layer 304, the emission layer or MQW's 305, and the pGaN layer 306. The time axis t denoted the time-lapses t₁, t₂, t₃, t₄, and so on for the mesa fabrication process.

For instance, a first hard mask may be employed to define the trench or cut 310 at the first instance t₁. At the consecutive second instance t₂, a second hard mask to define the partial mesa structure 301 may follow the first hard mask. As such, during the mesa etch 301, both the etch front of the trench 311 and the mesa 301 may progress together. It is to be noted, the etch process may be optimized such that the MQW's are cut everywhere on the wafer at the point when the mesa etch front is pre-endpointed before it reaches the MQW's.

In Fig. 4B, the sidewall effects of the mesa structures 303 of Figs. 3A-3B are illustrated. As it can be seen, the upper part of the mesa structure 303 contains the partial mesa structure with the clear characteristics that the emission layer 305 is not etched, thereby causing no damage to its emission profile. Depending on how much of the nGaN layer 304 is still present above the emission layer 305, the neighboring mesa structures may not be completely electrically isolated. However, the isolation can be fully achieved by the application of the trench 311. The partial mesa structure, especially the etching of said mesa's ideally defines the area of the QW's in which electrons will be injected and will emit light.

The lower part of the mesa structure 303 contains the relatively narrow trench 311, especially in the middle between the mesa intended to cut through the QW's, thereby effectively electrically isolating the mesa's. Because the location of this trench 311, i.e. farther away from the center of the mesa and outside the light emitting zone, the area of the QW's affected by the sidewall damage 401, 402 is also farther away from the center. This results in a larger area (emission area shown with the outwards radiating arrows) that is unaffected by the non-radiative recombination phenomena.

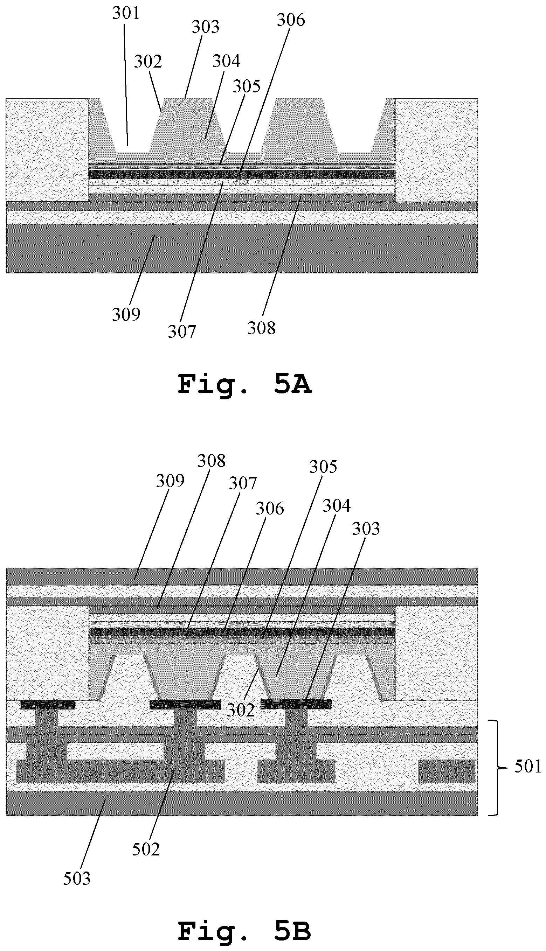

In Figs. 5A-5E, a second exemplary embodiment of the fabrication process according to the invention is illustrated. Particularly, Fig. 5A shows a first process step to etch partial mesa structures 303 on an incoming epitaxial LED material die. The first process step of Fig. 5A may correspond to the first etch step of Fig. 3A, especially the partial mesa fabrication scheme and the alternatives described therein.

Ideally, the epitaxial LED material die includes an n-doped layer or nGaN layer 304, a p-doped layer or a pGaN layer 306, an emission layer or MQW's 305 in-between the nGaN and the pGan layers, an ITO layer 307 underneath the pGaN layer 306, a number of dielectric films 308 underneath the ITO layer 307, and the silicon wafer 309.

Fig. 5A further shows the application of a first mask 301 that assigns the shape of sidewalls 302 of the mesa structures 303. Accordingly, the mesa's 303 are etched from the nGaN layer 304 up to the MQW's 305, resulting in partial mesa structures. In other words, the partial mesa structures 303 may not be electrically isolated depending on how much the nGaN material is left above the MQW's 305.

It is to be noted that the partial mesa structures 303 are etched to approach the MQW's 305 as closely as possible without etching the MQW layer in order to define the emission zone of the MQW's 305. Additionally, in order to achieve high reliability in the etching process, the epitaxial LED material die may be pre-formulated by having an additional layer (not shown) in the nGaN layer 304, and can be utilized as a etch stop layer during the partial mesa formation.

In Fig. 5B, a second process step of the second exemplary embodiment of the fabrication process is illustrated. In this regard, the processed epitaxial LED material die according to Fig. 5A is hybrid bonded, especially by means of wafer-to-wafer hybrid bonding, to a second semiconductor wafer 501, where a CMOS IC is pre-processed on the second semiconductor wafer 501. Preferably, a plurality of contact layers is processed on the nGaN layer 304, especially on top of each of the partial mesa structures 303.

Generally, the second semiconductor wafer 501 is processed on a silicon wafer 503 (e.g. a 775um silicon wafer) comprising a plurality of contacts 502 to form the CMOS IC. The contacts 502 are employed to facilitate an electrical connection between the CMOS IC and the respective contact layer on the top of the mesa structures 303, i.e. to the individual LEDs or pixels. It is further to be noted that additional bonding surface or material (e.g. SiCN) is implemented on top of each of the mesa structures in order to facilitate dielectric bonding with respect to the target contacts of the CMOS IC.

It is to be noted that hybrid bonding generally forms an attachment that combines two different kinds of bonds, especially a dielectric bond and a metal bond, where the latter is usually embedded in a dielectric bonding surface. In particular, the process conditions may be chosen as for conventionally known bonding techniques, i.e. temperature, pressure, and so on. Additionally, a post bond annealing may be applied in order to improve the overall bond shear strength.

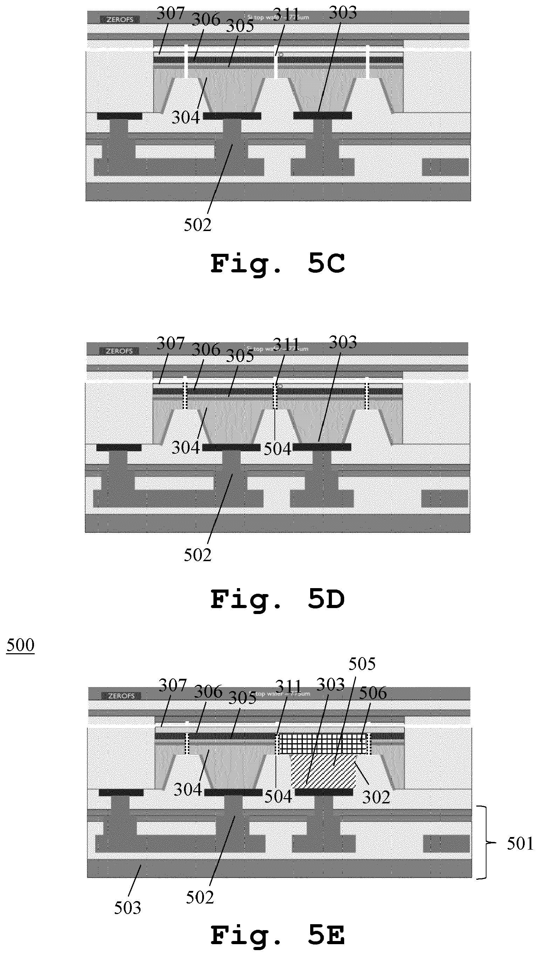

In Fig. 5C, a third process step of the second exemplary embodiment of the fabrication process is illustrated. The inverted mesa structures 303 are shown here because of the hybrid bonding onto the CMOS IC. During this step, the silicon wafer 309, and further the dielectric layers 308 are etched, e.g. by means of a Chemical-Mechanical Planarization (CMP) process. Afterwards, a second mask is applied that defines the trench 311, especially from the pGaN side of the mesa structures 303, through the ITO layer 307, the pGaN layer 306, the emission layer 305, and finally through any residual nGaN material 304.

This successfully isolates the pixels electrically. The application of the second mask to perform the cut or trench 311 may correspond to the second etch step of Fig. 3B, especially the trench etch scheme and the alternatives described therein.

In Fig. 5D, a fourth process step of the second exemplary embodiment of the fabrication process is illustrated. During this step, the trench 311 may be optionally filled with a filling material 504. The filling material 504 may be a dielectric material (e.g. SiN materials), a reflective material, or a metal. Further, prior to the application of the filling material 504, the damaged sides (i.e. the damaged sides of the etched MQW's) around the trench 311 may be passivated via atomic layer deposition, ion implantation, bombarding with plasma, or any combination thereof.

In Fig. 5E, a fifth process step of the second exemplary embodiment of the fabrication process is illustrated. During this step, the common electrode, e.g. the ITO layer 307, on top of the pGaN layer 306 is restored.

As such, the optical device 500 comprises a plurality of light emitting mesa structures that includes the partial mesa structures 303 that are etched in the nGaN layer 304 and are etched up to the MQW's 305. The optical device 500 further includes the CMOS IC fabricated on a second semiconductor wafer 501, where the respective partial mesa structures are hybrid bonded (e.g. flip-chip and wafer-to-wafer bonding) to the CMOS IC. The optical device 500 further includes the trenches 311 in-between two neighboring partial mesa structures 303 that are etched from the pGaN layer 306, especially through the MQW's 305 and any remaining portion of the nGaN layer 306, and may optionally include the filling material 504 within the trenches 311.

For instance, the exemplary light emitting mesa structure 303 may be formed as a partial mesa shape that may include a mesa part 505 followed by an offset part 506. In this regard, the shape or geometry of said mesa part 505 may be defined by the mesa sidewall 302 and the elongation of said offset part 506 especially respecting the mesa sidewall 302 may be defined by the trench 311. For the exemplary light emitting mesa structure 303, the mesa part 505 may comprise the first doped layer 304 and the offset part 506 may comprise at least the emission layer 305 and the second doped layer 306. Additionally, the offset part 506 may comprise a portion of the first doped layer 304.

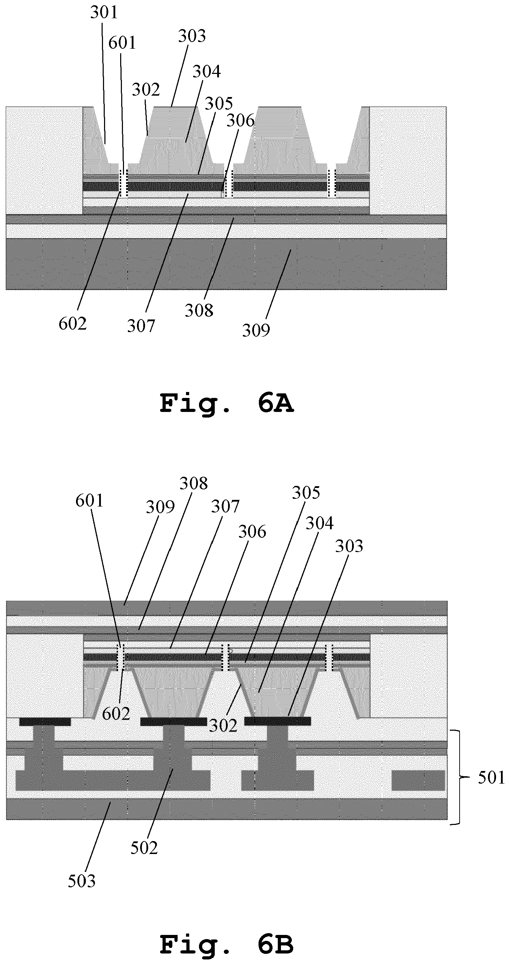

In Figs. 6A-6E, a third exemplary embodiment of the fabrication process according to the invention is illustrated. Particularly, Fig. 6A shows a first process step to etch partial mesa structures 303 on an incoming epitaxial LED material die and to successively etch a trench 601 between two adjacent partial mesa structures 303.

The epitaxial LED material die includes an n-doped layer or a nGaN layer 304, a p-doped layer or a pGaN layer 306, an emission layer or MQW's 305 in-between the nGaN and the pGan layers, an ITO layer 307 underneath the pGaN layer 306, a number of dielectric films 308 underneath the ITO layer 307, and the silicon wafer 309.

A first mask 301 is applied that assigns the shape of sidewalls 302 of the mesa structures 303. Accordingly, the mesa's 303 are etched from the nGaN layer 304 up to the MQW's 305, resulting in partial mesa structures. In other words, the partial mesa structures 303 may not be electrically isolated depending on how much the nGaN material is left above the MQW's 305. It is to be noted that the partial mesa structures 303 are etched to approach the MQW's 305 as closely as possible without etching the MQW layer in order to define the emission zone of the MQW's 305.

Additionally, in order to achieve high reliability in the etching process, the epitaxial LED material die may be pre-formulated to have an additional layer (not shown) in the nGaN layer 304 or between the nGaN layer 304 and the emission layer 305, which can be utilized as a etch stop layer during the partial mesa formation.

Further, a second mask is applied that assigns the shape of a trench or cut 601, especially to be etched between two adjacent partial mesa structures 303. For instance, the trench 601 is etched from the residual nGaN layer 304 above the MQW's 305, or from the etch stop layer if implemented, and is etched through the MQW's 305, the pGaN layer 306, and through a part or the whole ITO layer 307.

Preferably, in a first etch step, the mesa 303 is printed and is etched. In a second etch step, the trench or cut 601 is subsequently printed and is etched. As such, a Litho-Etch-Litho-Etch technique can be used to achieve the above-mentioned sequential etching.

Alternatively, it is possible to perform a partial trench etch followed by mesa etch. As such, during the mesa etch, both the etch front of the trench and the mesa progress together. In this regard, the etch process is optimized such that the MQW's are cut everywhere on the wafer at the point when the mesa etch front is pre-endpointed before it reaches the MQW's.

The trench 601 is preferably a deep cut that is applied through all the conductive layers, including the ITO layer 307, in order to provide effective electrical isolation. Furthermore, the trench 601 is etched as far away as possible from the center of the mesa structures or partial mesa structures 303, especially to pull the damaged zone as far away as possible from the emission zone.

Preferably, the damaged sides (i.e. the damaged sides of the etched MQW's) around the trench 601 may be passivated via atomic layer deposition, ion implantation, bombarding with plasma, or any combination thereof. Further, the trench 601 may be filled with a dielectric material (e.g. oxides) 602.

In Fig. 6B, a second process step of the third exemplary embodiment of the fabrication process is illustrated. In this regard, the processed epitaxial LED material die according to Fig. 6A is hybrid bonded, especially by means of wafer-to-wafer hybrid bonding, to a second semiconductor wafer 501, where a CMOS IC is pre-processed on the second semiconductor wafer 501. Preferably, a plurality of contact layers is processed on the nGaN layer 304, especially on top of each of the partial mesa structures 303.

Generally, the second semiconductor wafer 501 is processed on a silicon wafer 503 (e.g. a 775um silicon wafer) comprising a plurality of contacts 502 to form the CMOS IC. The contacts 502 are employed to facilitate an electrical connection between the CMOS IC and the respective contact layer on the top of the mesa structures 303, i.e. to the individual LEDs or pixels. It is further to be noted that additional bonding surface or material (e.g. SiCN) is implemented on top of each of the mesa structures in order to facilitate dielectric bonding with respect to the target contacts of the CMOS IC. Additionally, a post bond annealing may be applied in order to improve the overall bond shear strength.

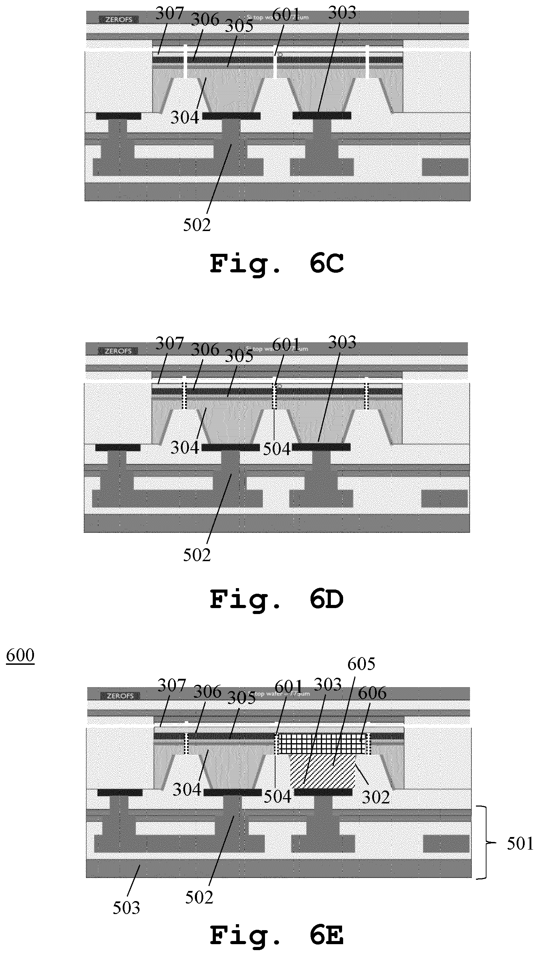

In Fig. 6C, a third process step of the third exemplary embodiment of the fabrication process is illustrated. The inverted mesa structures 303 are shown here because of the hybrid bonding onto the CMOS IC. During this step, the silicon wafer 309, and further the dielectric layers 308 are etched, e.g. by means of a Chemical-Mechanical Planarization (CMP) process. Afterwards, the dielectric material 602, especially used to fill the trench 601 during the first process step, is removed.

In Fig. 6D, a fourth process step of the third exemplary embodiment of the fabrication process is illustrated. During this step, the trench 601 may be optionally filled with a filling material 504. The filling material 504 may be a dielectric material (e.g. SiN materials), a reflective material, or a metal. Further, prior to the application of the filling material 504, the damaged sides (i.e. the damaged sides of the etched MQW's) around the trench 601 may be passivated via atomic layer deposition, ion implantation, bombarding with plasma, or any combination thereof, if it was not performed during the first process step.

In Fig. 6E, a fifth process step of the third exemplary embodiment of the fabrication process is illustrated. During this step, the common electrode, e.g. the ITO layer 307, on top of the pGaN layer 306 is restored.

As such, the optical device 600 comprises a plurality of light emitting mesa structures that includes the partial mesa structures 303 that are etched in the nGaN layer 304 and are etched up to the MQW's 305. The optical device 500 further includes the trenches 601 in-between two neighboring partial mesa structures 303 that are etched from the nGaN layer 306, especially through the MQW's 305, the pGaN layer 306, and partially or fully trough the ITO layer 307, and may optionally include the filling material 504 within the trenches 311. The optical device 500 further includes the CMOS IC fabricated on a second semiconductor wafer 501, where the respective partial mesa structures are hybrid bonded (e.g. flip-chip and wafer-to-wafer bonding) to the CMOS IC.

For instance, the exemplary light emitting mesa structure 303 may be formed as a partial mesa shape that may include a mesa part 605 followed by an offset part 606. In this regard, the shape or geometry of said mesa part 605 may be defined by the mesa sidewall 302 and the elongation of said offset part 606 especially respecting the mesa sidewall 302 may be defined by the trench 311. For the exemplary light emitting mesa structure 303, the mesa part 605 may comprise the first doped layer 304 and the offset part 606 may comprise at least the emission layer 305 and the second doped layer 306. Additionally, the offset part 606 may comprise a portion of the first doped layer 304.

As discussed before, the traditional way of defining pixels in micro-LED arrays is performed by etching mesa's into the III/V material. In most cases, especially to guarantee electrical isolation of neighboring pixels, the QW's are also etched. This results in sidewall damage of the QW's leading to non-radiative recombination on these sidewalls, in turn leading to loss of light emission. This effect can somewhat be mitigated by repairing the sidewalls.

The invention proposes an alternative way to pattern the mesa structures, where the top part of the mesa remains the traditional shape (i.e. defining the light emitting area) and where electrical isolation is done in the lower part of the mesa through a narrow cut or trench etching through the QW's. Using a narrow cut moves the damage part of the QW farther away from the light emitting area of the QW's. This approach can still be combined with the conventional repair methods to even further improve light emission.

It is important to note that the word "comprising" does not exclude other elements or steps and the indefinite article "a" or "an" does not exclude a plurality. A single element or other unit may fulfill the functions of several entities or items recited in the claims. Moreover, the description with regard to any of the aspects is also relevant with regard to the other aspects of the invention.

Although the invention has been illustrated and described with respect to one or more implementations, equivalent alterations and modifications will occur to others skilled in the art upon the reading and understanding of this specification and the annexed drawings. In addition, while a particular feature of the invention may have been disclosed with respect to only one of several implementations, such feature may be combined with one or more other features of the other implementations as may be desired and advantageous for any given or particular application.

## Claims

1. A method (100) for making light emitting mesa structures (303) on a semiconductor wafer, each mesa structure comprising a first doped layer (304), a second doped layer (306), and an emission layer (305) in-between, the method comprises:
providing a first mask (301) for assigning a shape of a sidewall (302) of the mesa structures (303),
etching from the first doped layer (304) according to the first mask (301) up to the emission layer (305),
providing a second mask (310) for assigning a shape of a trench (311) between two adjacent mesa structures (303), and
etching the trench (311) through the emission layer (305) according to the second mask (310),
wherein the trench (311) is nonadjacent to the sidewall (302) of the mesa structures (303).

2. The method according to claim 1,
wherein the method comprises:
providing a stop layer between the first doped layer (304) and the emission layer (305),
etching from the first doped layer (304) according to the first mask (301) up to the stop layer above the emission layer (305), and
etching the trench (311) from the stop layer through the emission layer (305) according to the second mask (310).

3. The method according to claim 1 or 2,
wherein the etching from the first doped layer (304) according to the first mask (301) is performed in a first etch step and the etching of the trench (311) through the emission layer (305) according to the second mask (310) is performed in a second etch step, and
wherein the first etch step and the second etch step are performed sequentially, and/or
wherein the etching from the first doped layer (304) according to the first mask (301) and the etching of the trench (311) through the emission layer (305) according to the second mask (310) are perform simultaneously.

4. The method according to claim 1,
wherein the method comprises:
providing the first mask (301) for assigning the shape of the sidewall (302) of the mesa structures (303),
etching from the first doped layer (304) according to the first mask (301) up to the emission layer (305),
providing a silicon based carrier substrate (501) and hybrid bonding the semiconductor wafer to the silicon based carrier substrate (501) on the first doped layer (304) side,
providing the second mask (310) for assigning the shape of the trench (311) between two adjacent mesa structures (303),
etching the trench (311) from the second doped layer (306) through the emission layer (305) according to the second mask (310),
wherein the trench (311) is nonadjacent to the sidewall (302) of the mesa structures (303).

5. The method according to claim 4,
wherein the method comprises:
providing a stop layer between the first doped layer (304) and the emission layer (305),
etching from the first doped layer (304) according to the first mask (301) up to the stop layer above the emission layer (305), and
etching the trench (311) from the second doped layer (306) up to the stop layer through the emission layer (305) according to the second mask (310).

6. The method according to any of claims 1 to 5,
wherein the method further comprises the step of passivating exposed areas along the trench (311), whereby the passivating step comprises performing atomic layer deposition and/or ion implantation and/or bombarding with plasma, and/or
wherein the method further comprises the step of filling the trench (311) with a filling material (504), whereby the filling material (504) is a reflective material or a dielectric material or a metal.

7. An optical device (300, 500, 600) comprising:
a plurality of light emitting mesa structures (303) on a semiconductor wafer, each mesa structure comprising a first doped layer (304), a second doped layer (306), and an emission layer (305) in-between,
wherein a sidewall (302) of the mesa structures is configured to be etched from the first doped layer (304) up to the emission layer (305) according to a first mask (301),
wherein a trench (311) is configured to be etched through the emission layer (305) between two adjacent mesa structures (300) according to a second mask (310), and
wherein the trench (311) is nonadjacent to the sidewall (302) of the mesa structures (303).

8. The optical device according to claim 7,
wherein the plurality of light emitting mesa structures (303) each have a partial mesa shape comprising a mesa part (505, 605) defined by the sidewall (302) followed by an offset part (506, 606) defined by the trench (311).

9. The optical device according to claim 8,
wherein the mesa part (505, 605) comprises the first doped layer (304) and the offset part (506, 606) comprises at least the emission layer (305) and the second doped layer (306) .

10. The optical device according to any of claims 7 to 9, wherein the optical device further comprises a silicon based carrier substrate (501) and wherein the semiconductor wafer is hybrid bonded to the silicon based carrier substrate (501) on the first doped layer (304) side.

11. The optical device according to any of claims 7 to 10, wherein the optical device further comprises a common contact layer (307) on the second doped layer (306) along the plurality of light emitting mesa structures (303).

12. The optical device according to any of claims 7 to 11, wherein the first doped layer (304) is a n-doped layer, especially a n-type Gallium Nitride (nGaN) layer, and/or the second doped layer (306) is a p-doped layer, especially a p-type Gallium Nitride (pGaN) layer, and/or the emission layer (305) is a quantum well layer, especially a Indium Gallium Nitride (InGaN) and/or Gallium Nitride (GaN) based multiple quantum well (MQW) multi-layer.

13. The optical device according to any of claims 7 to 12, wherein the shape of the sidewall (302) of the mesa cross-section structures is a slope shape.

14. The optical device according to any of claims 7 to 13, wherein the shape of the trench (311) cross-section is a square shape or a slope shape or a V-shape.

15. The optical device according to any of claims 7 to 14, wherein the trench (311) has a dimension at least of one-tenth of a dimension of the mesa structures (303).
